# EUROPEAN PATENT APPLICATION

(11) **EP 4 654 470 A1**
(43) Date of publication of application: **26.11.2025**
(21) Application number: 23917619.1
(22) Date of filing: 31.10.2023
(51) Int. Cl.: H03F 1/22, H03F 3/42, H03F 3/45, H03G 3/10

(54) **PHASE INVERTED AMPLIFIER**

(30) Priority: 16.01.2023 JP 2023004431
(71) Applicant: Fujikura Ltd., Tokyo 135-8512 (JP)
(72) Inventor: KUBO, Tatsuo, Sakura-shi, Chiba 285-8550 (JP); YAMAGUCHI, Yo, Sakura-shi, Chiba 285-8550 (JP)
(74) Representative: Lavoix
(86) International application number: PCT/JP2023/039279
(87) International publication number: WO 2024/154407

(57) **Abstract**

A phase inverted amplifier includes: an amplifying transistor that amplifies an input signal, two electronic switches each having a first end that is connected to an output end of the amplifying transistor, and that have ON/OFF states which are controlled by two control signals, and a transformer that includes a primary winding connected between two second ends of the two electronic switches, and a secondary winding that outputs an amplification signal from a first end.

## Description

### Technical Field

The present invention relates to a phase inverted amplifier.

The present application is based on Japanese Unexamined Patent Application, First Publication No. 2023-004431, filed on 16 January 2023, with contents thereof being incorporated herein by reference.

### Background Art

In Non-Patent Document 1, an RF amp having a phase inversion function used in a wireless transmission system is disclosed. Such RF amp is configured as a circuit block where an amp (LNA) and a phase inverted circuit (PI) are independent, and has a balun disposed so as to convert a single end signal to a differential signal at a step prior to the phase inversion circuit, in relation to the need to input the differential signal to the phase inversion circuit.

### Citation List

### Patent Documents

Non-Patent Document 1: B. Sadhu et al.,"A 24-to-30GHz 256-Element Dual-Polarized 5G Phased Array with Fast Beam Switching Support for >30,000 Beams", 2022 IEEE Int'Solid-State Circuits Conf. (ISSCC), pp 436-437, Feb. 2022. Fig27.3.1

### Summary of the Invention

### Problem to be Solved by the Invention

Although the aforementioned RF amp having a phase inversion function is an embodiment of a phase inverted amplifier, a configuration where an amp (LNA) and a phase inversion circuit (PI) are independently provided is utilized, and since there is a need to provide a balun at the step before the differential converter circuit, there are cases where circuit size and power consumption become large. For example, when configuring the RF amp having a phase inversion function as an integrated circuit (IC), there are cases where an IC size becomes large, and it is possible that power consumption thereof increases as well.

The present disclosure is made with the aforementioned problem in mind, and an object thereof is to provide a phase inverted amplifier where it is possible to have a smaller size circuit than conventional, along with less power consumption than conventional.

### Means to Solve the Problem

To achieve the above objective, a phase inverted amplifier according to a first aspect of the present disclosure includes an amplifying transistor that amplifies an input signal, two electronic switches each having a first end that is connected to an output end of the amplifying transistor, and that have ON/OFF states which are controlled by two control signals, and a transformer that includes a primary winding connected between two second ends of the two electronic switches, and a secondary winding that outputs an amplification signal from a first end.

In the phase inverted amplifier of the present disclosure according to a second aspect, in the first aspect, the primary winding may further include a first winding and a second winding, a first end of the first winding may be connected to the second end of one of the two electronic switches, a first end of the second winding may be connected to the second end of the other of the two electronic switches, and a second end of the first winding and a second end of the second winding may be connected to a power terminal. The secondary winding may further include a third winding and a fourth winding which may be connected in series, and a second end of the fourth winding may be connected to a ground terminal. The first winding and the third winding may be magnetically coupled to one another, the second winding and the fourth winding may be magnetically coupled to one another, and an amplification signal may be output from a first end of the third winding.

In the phase inverted amplifier of the present disclosure according to a third aspect, in the aforementioned first or second aspects, the two electronic switches may be switching transistors that are cascode connected to the amplifying transistor.

The phase inverted amplifier of the present disclosure according to a fourth aspect may include a circuit element that adjusts at least one out of frequency characteristics, gain, or output impedance, in any one of the aforementioned first to third embodiments.

The phase inverted amplifier of the present disclosure according to a fifth aspect may further include a gain adjustment circuit that adjusts a degree of amplification of the amplifying transistor, in any one of the aforementioned first to fourth embodiments.

### Effects of the Invention

According to the present disclosure, it is possible to provide a phase inverted amplifier that has a smaller circuit size than conventional, along with having less power consumption than conventional.

### Brief Description of Drawings

[FIG. 1] A circuit diagram that shows a configuration of a phase inverted amplifier according to a first embodiment of the present disclosure.
[FIG. 2A] A schematic diagram that shows operation of the phase inverted amplifier according to the first embodiment of the present disclosure.
[FIG. 2B] A schematic diagram that shows operation of the phase inverted amplifier according to the first embodiment of the present disclosure.
[FIG. 3] A circuit diagram that shows a configuration of the phase inverted amplifier according to a second embodiment of the present disclosure.
[FIG. 4] A circuit diagram that shows a configuration of the phase inverted amplifier according to a third embodiment of the present disclosure.
[FIG. 5] A circuit diagram that shows a configuration of the phase inverted amplifier according to a fourth embodiment of the present disclosure.

### Description of Embodiments

Hereinafter, embodiments of the present disclosure are explained with reference to the drawings.

### <First Embodiment>

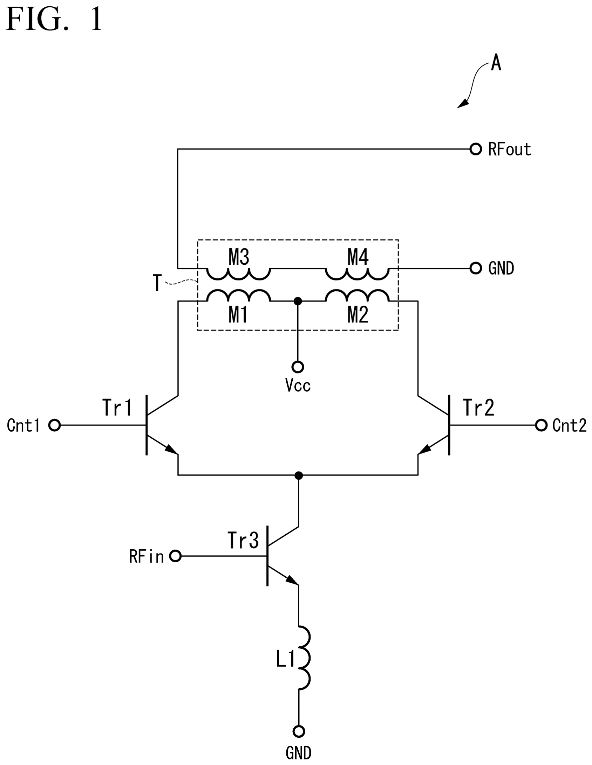

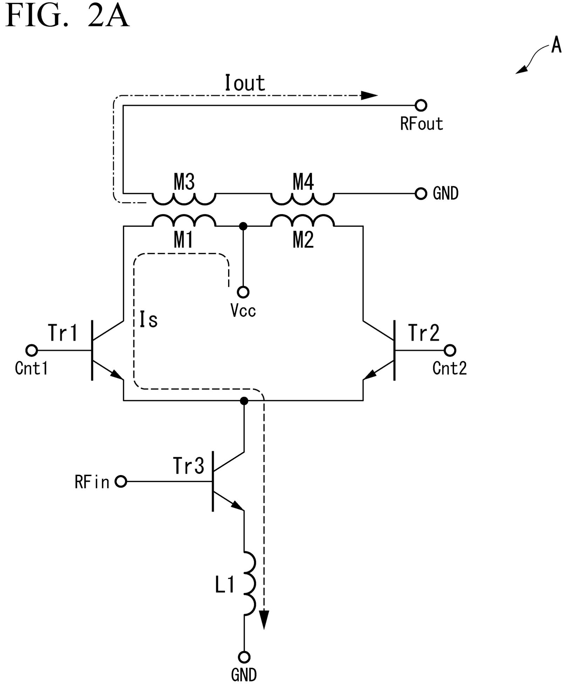

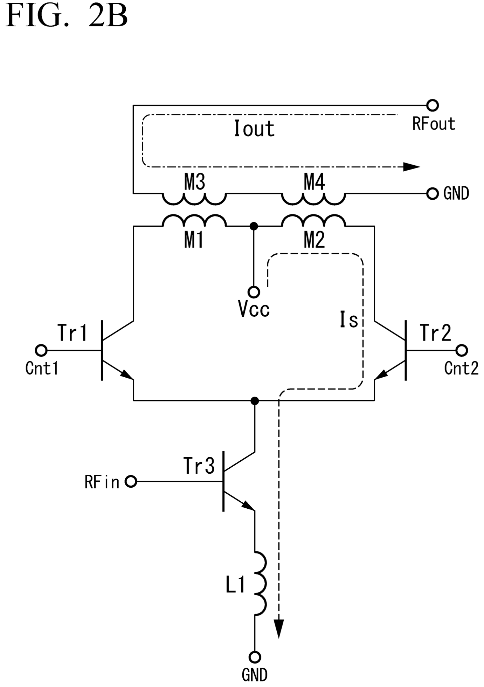

First, a first embodiment of the present disclosure is explained with reference to FIG. 1, FIG. 2A, and FIG. 2B. As shown in FIG. 1, a phase inverted amplifier A according to the first embodiment includes a high frequency input terminal RFin, a high frequency output terminal RFout, a first transistor Tr1, a second transistor Tr2, a third transistor Tr3, a first control terminal Cnt1, a second control terminal Cnt2, a coil L1, a transformer T, a power terminal Vcc, and a ground terminal GND. The above transformer T includes four windings, i.e. a first winding M1, a second winding M2, a third winding M3, and a fourth winding M4.

The high frequency input terminal RFin is an input terminal of the phase inverted amplifier A, and is connected to a base terminal of the third transistor Tr3. A high frequency signal at a predetermined frequency is input to the high frequency input terminal RFin from an outside. Such high frequency signal is the input signal at the phase inverted amplifier A, and is applied to the base terminal of the third transistor Tr3.

The high frequency output terminal RFout is an output terminal of the phase inverted amplifier A, and is connected to a first end of the third winding M3 at the transformer T. The high frequency output terminal RFout outputs the input signal, which is amplified by the phase inverted amplifier A to become a high frequency amplification signal, to the outside.

The first transistor Tr1 is an NPN type bipolar transistor, as shown in the drawing, having a base terminal connected to the first control terminal Cnt1. An emitter terminal of the first transistor Tr1 is connected to an emitter terminal of the second transistor Tr2 and a collector terminal of the third transistor Tr3, and a collector terminal of the first transistor Tr1 is connected to a first end of the first winding M1.

Same as with the first transistor Tr1, the second transistor Tr2 is an NPN type bipolar transistor, having a base terminal connected to the second control terminal Cnt2. The emitter terminal of the second transistor Tr2 is connected to an emitter terminal of the first transistor Tr1 and a collector terminal of the third transistor Tr3, and a collector terminal of the second transistor Tr2 is connected to a first end of the second winding M2.

The third transistor Tr3 is also an NPN type bipolar transistor, having a base terminal connected to the high frequency input terminal RFin. An emitter terminal of the third transistor Tr3 is connected to a first end of the coil L1, and a collector terminal of the third transistor Tr3 is connected the emitter terminal of the first transistor Tr1 and the emitter terminal of the second transistor Tr2.

The first control terminal Cnt1 is connected to the base terminal of the first transistor Tr1, and a first control signal is applied to the first control terminal Cnt1 from the outside. The first control signal is a binary signal that sets the first transistor Tr1 to an ON state or an OFF state. In other words, the first transistor Tr1 is in the ON state (conductive state) when a level of the first control signal is Hi (high), and is in the OFF state (nonconductive state) when the level of the first control signal is Lo (low).

The second control terminal Cnt2 is connected to the base terminal of the second transistor Tr2, and a second control signal is applied to the second control terminal Cnt2 from the outside. The second control signal is a binary signal that sets the second transistor Tr2 to an ON state or an OFF state. In other words, the second transistor Tr2 is in the ON state (conductive state) when a level of the second control signal is Hi (high), and is in the OFF state (nonconductive state) when the level of the second control signal is Lo (low).

The aforementioned third transistor Tr3 is an amplifying transistor that functions as an amplifying element. The first transistor Tr1 and the second transistor Tr2 are switching transistors that function as electronic switches. The first transistor Tr1 is one electronic switch, and the second transistor Tr2 is the other electronic switch. The collector terminal of the third transistor Tr3 is an output terminal of the third transistor Tr3 (amplifying transistor).

In other words, a first end of each of the first transistor Tr1 and of the second transistor Tr2, or the emitter terminal of each, is connected to an output end of the third transistor Tr3 (amplifying transistor), and is cascode connected to the third transistor Tr3 (amplifying transistor). The first transistor Tr1 and the second transistor Tr2 are two electronic switches having an ON/OFF state thereof controlled using the first control signal and the second control signal, which are the two control signals.

The coil L1 includes a first inductance, and has a first end thereof connected to the emitter terminal of the third transistor Tr3, and the second end thereof connect to the ground terminal GND. The coil L1 is a circuit element for setting up a degree of amplification of the phase inverted amplifier A. In other words, the degree of amplification of the phase inverted amplifier A is setup using the first inductance, the transformer T, and collector current of the third transistor Tr3.

The transformer T includes the first winding M1, the second winding M2, the third winding M3, and the fourth winding M4 as mentioned above, and as shown in FIG. 1, is provided on a collector terminal side of the first transistor Tr1 and the second Transistor Tr2. In other words, the first end of the first winding M1 is connected to the collector terminal of the first transistor Tr1, and the second end of the first winding M1 is connected to the second end of the second transistor M2 and the power terminal Vcc.

The first end of the second winding M2 is connected to the collector terminal of the second transistor Tr2, and the second end of the second winding M2 is connected to the second end of the first winding M1 and the power terminal Vcc. The first end of the third winding M3 is connected to the high frequency output terminal RFout, and the second end of the third winding M3 is connected to a first end of the fourth winding M4. The first end of the fourth winding M4 is connected to the second end of the third winding M3, and the second end of the fourth winding M4 is connected to the ground terminal GND. In other words, the first end of the fourth winding M4 is connected to the third winding M3, and the second end of the fourth winding M4 is connected to the ground terminal GND.

In the transformer T, the first winding M1 and the second winding M2 are connected in series, and the third winding M3 and the fourth winding M4 are connected in series. The first winding M1 and the second winding M2 are set to first number of windings, and configure primary winding of the transformer T. The third winding M3 and the fourth winding M4 are set to second number of windings, and configure secondary winding of the transformer T.

In the aforementioned transformer T, the primary winding is connected between the collector terminals (between the two second ends) at the first transistor Tr1 and the second transistor Tr2 (two electronic switches), and the first end of the secondary winding is connected to the high frequency output terminal RFout (output end of the phase inverted amplifier A).

In the aforementioned transformer T, the first winding M1 and the third winding M3 are magnetically coupled, and the second winding M2 and the fourth winding M4 are magnetically coupled to one another. A magnetic coupling coefficient of the first winding M1 and the third winding M3 is the same as the magnetic coupling coefficient of the second winding M2 and the fourth winding M4. The transformer T includes a primary inductance that is set by individual inductances of the first winding M1, the second winding M2, the third winding M3, and the fourth winding M4, along with the magnetic coupling coefficients.

The power terminal Vcc is connected to the second end of the first winding M1 and the second end of the second winding M2 in the aforementioned transformer T. In other words, the power terminal Vcc is connected to a center tap of the primary winding in the transformer T. The power terminal Vcc is connected to a direct current voltage power supply of a predetermined power supply voltage on the outside.

The ground terminal GND is connected to the second end of the coil L1 and the second end of the fourth winding M4, as shown on the drawings. The ground terminal GND is a ground connection on the outside. In other words, the ground terminal GND is set to have a potential (ground potential) that is lower than the potential of the power terminal Vcc.

Next, operations of the phase inverted amplifier A according to the aforementioned first embodiment is explained in further detail.

In the phase inverted amplifier A, the first transistor Tr1 and the second transistor Tr2 function as two electronic switches which have the ON/OFF states controlled by the first control signal and the second control signal (the two control signals) mentioned above. The first control signal and the second control signal are two control signals that complimentarily set the ON state and the OFF state of the first transistor Tr1 and the second transistor Tr2.

In other words, using the first control signal and the second control signal, when one of the first transistor Tr1 or the second transistor Tr2 is set to the ON state, the other is set to the OFF state. For example, when the first transistor Tr1 is in the ON state, the second transistor Tr2 is in the OFF state.

FIG. 2A shows a current path of current in a case where the first transistor Tr1 is in the ON state, and the second transistor Tr2 is in the OFF state. On the other hand, FIG. 2B shows the current path of the current in a case where the second transistor Tr2 is in the ON state, and the first transistor Tr1 is in the OFF state.

When the first transistor Tr1 is in the ON state, the high frequency signal (input signal) that is input to the high frequency input terminal RFin from the outside becomes the high frequency amplification signal that is amplified at the third transistor Tr3, and is input to the transformer T via the first transistor Tr1.

In the above case, as shown in FIG. 2A, an amplification current Is flows in the order of the power terminal Vcc → first winding M1 → first transistor Tr1 → third transistor Tr3 → coil L1 → ground terminal GND. Since the first winding M1 and the third winding M3 are magnetically coupled, an output current Iout induced by the amplification current Is flows from the secondary winding (the third winding M3 and the fourth winding M4) towards the high frequency output terminal RFout. In other words, a direction in which the output current Iout flows in is the direction from the ground terminal GND to the high frequency output terminal RFout (first direction).

On the other hand, in a case where the second transistor Tr2 is in the ON state, the high frequency signal (input signal) that is input from the outside to the high frequency input terminal RFin becomes the high frequency amplification signal, which is amplified at the third transistor Tr3, and is input to the transformer T via the second transistor Tr2.

In such case, as shown in FIG. 2B, the amplification current Is flows in the order of power terminal Vcc → second winding M2 → second transistor Tr2 → third transistor Tr3 → coil L1 → ground terminal GND. Since the second winding M2 and the fourth winding M4 are magnetically coupled, the output current Iout induced by the amplification current Is flows from the secondary winding (the third winding M3 and the fourth winding M4) towards the ground terminal GND. In other words, a direction in which the output current Iout flows in is the direction from the high frequency output terminal RFout to the ground terminal GND (second direction).

According to the aforementioned first embodiment, depending on which out of the first transistor Tr1 or the second transistor Tr2 is set to the ON state, the direction in which the output current Iout flows is reversed. In other words, depending on which out of the first transistor Tr1 or the second transistor Tr2 is set to the ON state, a phase of the high frequency amplification signal at the high frequency output terminal RFout is reversed.

Therefore, according to the first embodiment, since the phase inverted amplifier A includes the third transistor Tr3 (amplifying transistor), the first transistor Tr1 and the second transistor Tr2 (two electronic switches), and the transformer T, it is possible to provide the phase inverted amplifier A having a smaller size circuit along with less power consumption, compared to a conventional circuit such as the RF amp with phase inversion function in Non-Patent Document 1.

### <Second Embodiment>

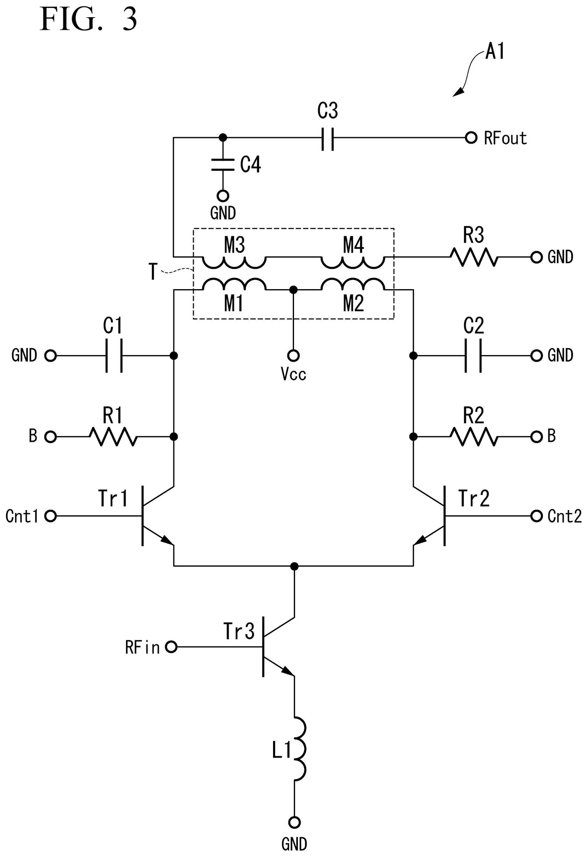

Next, a second embodiment of the present disclosure is explained with reference to FIG. 3. As shown in FIG. 3, a phase inverted amplifier A1 according to the second embodiment has the same configuration as the phase inverted amplifier A in the first embodiment, with the addition of a first resistor R1, a second resistor R2, a third resistor R3, a first capacitor C1, a second capacitor C2, a third capacitor C3, a fourth capacitor C4, and a bias terminal B.

The first resistor R1, the second resistor R2, the third resistor R3, the first capacitance C1, the second capacitance C2, the third capacitance C3, or the fourth capacitance C4 are circuit elements for adjusting at least one of a frequency characteristics, a gain (degree of amplification), or an output impedance of the phase inverted amplifier A1.

The first resistance R1 has a predetermined first resistance value, and the first end thereof is connected to the collector terminal of the first transistor Tr1, the first end of the first winding M1, and the first end of the first capacitor C1, while the second end thereof is connected to the bias terminal B. The second resistor R2 has a predetermined second resistance value, and the first end thereof is connected to the collector terminal of the second transistor Tr2, the first end of the second winding M2, and the first end of the second capacitor C2, while the second end thereof is connected to the bias terminal B.

The first resistor R1 and the second resistor R2 are additional elements for adjusting the gain and the output impedance at the phase inverted amplifier A1, and the first resistance value of the first resistor R1 and the second resistance value of the second resistor R2 are set so as to be the same value.

The third resistor R3 includes a predetermined third resistance value, and is provided between the fourth winding M4 and the ground terminal GND. In other words, a first end of the third resistor R3 is connected to the second end of the fourth winding M4, and the second end thereof is connected to the ground terminal GND. As with the first resistor R1 and the second resistor R2, the third resistor R3 is an additional element for adjusting the gain and the output impedance at the phase inverted amplifier A1.

The first capacitor C1 has a predetermined first electrostatic capacity, and the first end thereof is connected to the collector terminal of the first transistor Tr1, the first end of the first winding M1, and the first end of the first resistor R1, while the second end thereof is connected to the ground terminal GND. The second capacitor C2 has a predetermined second electrostatic capacity, and the first end thereof is connected to the collector terminal of the second transistor Tr2, the first end of the second winding M2, and the first end of the second resistor R2, while the second end thereof is connected to the ground terminal GND.

The above first capacitor C1 and the second capacitor C2 are additional elements for adjusting the frequency characteristics of the phase inverted amplifier A1. The first electrostatic capacity of the first capacitor C1 and the second electrostatic capacity of the second capacitor C2 are set so as to be the same value.

The third capacitor C3 has a predetermined third electrostatic capacity, and is provided between the third winding M3 and the high frequency output terminal RFout. In other words, the third capacitor C3 has the first end connected to the first end of the third winding M3 and the first end of the fourth capacitor C4, while the second end thereof is connected to the high frequency output terminal RFout. The third capacitor C3 is an AC coupling capacitor, and is an additional element for adjusting the frequency characteristics of the phase inverted amplifier A1.

The fourth capacitor C4 has a predetermined fourth electrostatic capacity, and the first end thereof is connected to the first end of the third winding M3 and the first end of the third capacitor C3, while the second end thereof is connected to the ground terminal GND. The fourth capacitor C4 is an additional element for adjusting the frequency characteristics of the phase inverted amplifier A1.

The bias terminal B is connected to the second end of the first resistor R1, and to the second end of the second resistor R2. The bias terminal B is connected to the power terminal Vcc.

According to the second embodiment, along with having a smaller size circuit which has less power consumption, compared to a conventional circuit such as the RF amp with phase inversion function in Non-Patent Document 1, it is also possible to provide a phase inverted amplifier A1 having the frequency characteristics, the gain (degree of amplification), and the output impedance thereof adjusted.

### <Third Embodiment>

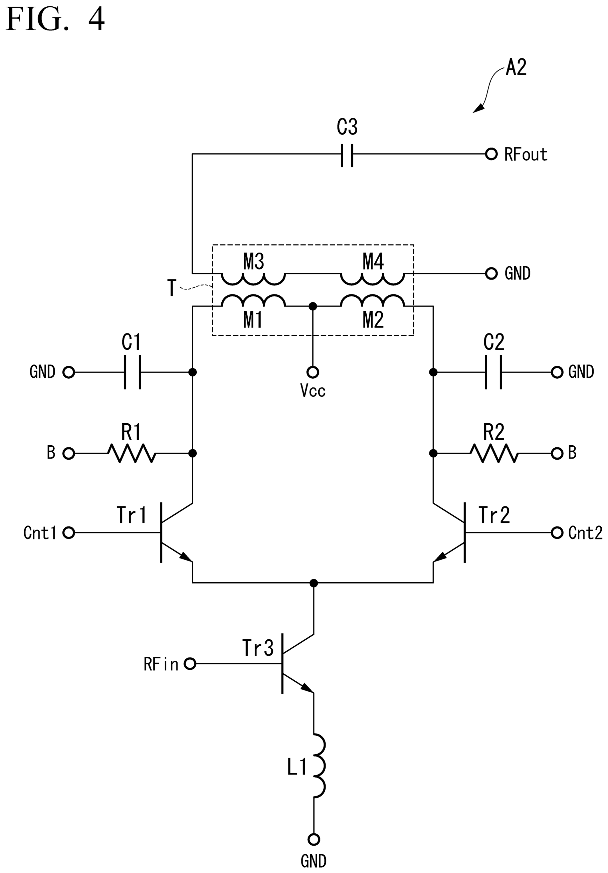

Next, a third embodiment of the present disclosure is explained with reference to FIG. 4. As shown in FIG. 4, added to the phase inverted amplifier A according to the first embodiment, a phase inverted amplifier A2 according to the third embodiment has a configuration which includes the first resistor R1, the second resistor R2, the first capacitor C1, the second capacitor C2, the third capacitor C3, and the bias terminal B.

The first resistor R1, the second resistor R2, the first capacitor C1, the second capacitor C2, the third capacitor C3, and the bias terminal B are circuit elements to adjust frequency characteristics, gain (degree of amplification), and output impedance of the phase inverted amplifier A2, and since the aforementioned are the same as the elements in the phase inverted amplifier A1 according to the second embodiment, explanations thereof are omitted.

According to the third embodiment, along with having a smaller size circuit which has less power consumption, compared to a conventional circuit such as the RF amp with phase inversion function in Non-Patent Document 1, it is also possible to provide the phase inverted amplifier A2 having the frequency characteristics, the gain (degree of amplification), and the output impedance thereof adjusted.

### <Fourth Embodiment>

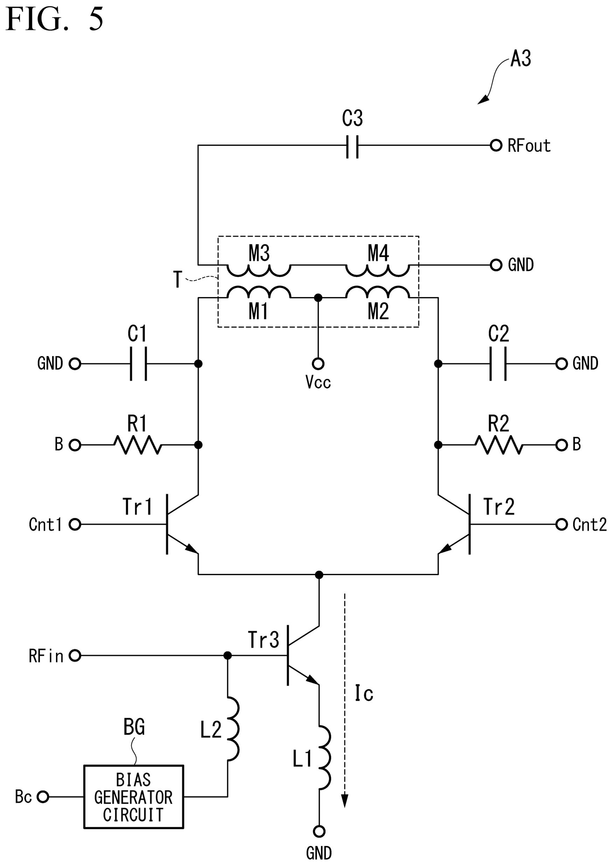

Next, a fourth embodiment of the present disclosure is explained with reference to FIG. 5. As shown in FIG. 5, added to the phase inverted amplifier A2 according to the third embodiment, a phase inverted amplifier A3 according to the fourth embodiment has a configuration which includes a bias generator circuit BG, a bias control terminal Bc, and a second coil L2.

The bias generator circuit BG has an input end connected to the bias control terminal Bc, and an output terminal connected to the first end of the second coil L2. The bias generator circuit BG generates a predetermined input bias voltage based on a bias control signal which is input from the bias control terminal Bc, and outputs the input bias voltage to the second coil L2.

The bias control terminal Bc is connected to an input terminal of the bias generator circuit BG, and a bias control signal is input thereto from an outside bias control device. Such bias control signal is a control signal for determining the input bias voltage. In other words, the bias control terminal Bc is provided so as to adjust the input bias voltage from the outside, using the bias control signal.

The second coil L2 has a second inductance, has a first end thereof connected to an output end of the bias generator circuit BG, and the second end thereof connected to the base terminal of the third transistor Tr3 and the high frequency input terminal RFin. The second coil L2 is a circuit element for regarding the bias generator circuit BG as high impedance at a desired high frequency.

The bias generator circuit BG, the bias control terminal Bc, and the second coil L2 are an additional circuit so as to add gain adjustment function to the phase inverted amplifier A3. In other words, the bias generator circuit BG, the bias control terminal Bc, and the second coil L2 function as a gain adjustment circuit in the phase inverted amplifier A3.

The gain adjustment circuit generates the input bias voltage according to the bias control signal that is input from the outside, and by outputting the input bias voltage to the base terminal of the third transistor Tr3, and sets the degree of amplification of the third transistor Tr3. In other words, by setting a collector current Ic of the third transistor Tr3 based on the bias control signal, the gain adjustment circuit sets the degree of amplification of the third transistor Tr3.

According to the fourth embodiment, along with the phase inverted amplifier A3 having a circuit size smaller than conventional, and the phase inverted amplifier A3 having power consumption less than conventional, it is also possible to provide the phase inverted amplifier A3 where the degree of amplification is adjustable from the outside.

The present disclosure is not limited to the aforementioned embodiments, and as an example, the following modification examples are possible.
(1) Although the amplification signal is only output from a first end of the secondary winding of the transformer T in each of the above embodiments, the present disclosure is not limited thereto. The amplification signal may be output from both ends of the secondary winding of the transformer T. In other words, output forms of the amplification signals of each of the phase inverted amplifiers A, A1, A2, and A3 may be made to be balanced forms, from unbalanced forms.
(2) Although an NPN type bipolar transistor is utilized in each of the aforementioned embodiments as the first transistor Tr1, the second transistor Tr2, and the third transistor Tr3 (amplifying transistor), the present disclosure is not limited thereto. A field-effect transistor, or some other form of transistor may be utilized.
(3) Although the coil L1 (inductive element) is connected to the emitter terminal of the third transistor Tr3 (amplifying transistor) in each of the embodiments above, the present disclosure is not limited thereto. A circuit element other than an inductive element may be connected to the emitter terminal of the third transistor Tr3 (amplifying transistor).
(4) Although the first resistor R1, the second resistor R2, the third resistor R3, the first capacitor C1, the second capacitor C2, the third capacitor C3, and the fourth capacitor C4 are circuit elements for adjusting the frequency characteristics, the gain (degree of amplification), and the impedance of the phase inverted amplifier A1 in the second embodiment, and the first resistor R1, the second resistor R2, the first capacitor C1, the second capacitor C2, and the third capacitor C3 are circuit elements for adjusting the frequency characteristics, the gain (degree of amplification), and the output impedance of the phase inverted amplifier A2 in the third embodiment, the present disclosure is not limited thereto.
(5) Although the first end (the fourth winding M4 side) of the secondary winding of the transformer T, which is configured of the third winding M3 and the fourth winding M4, is connected to the ground terminal GND via the third resistor R3, and the second end (the third winding M3 side) of the secondary winding is connected to the high frequency output terminal RFout via the third capacitor C3, the present disclosure is not limited thereto. The first end (the fourth winding M4 side) of the secondary winding may be connected to the high frequency output terminal RFout via the third capacitor C3, and the second end (the third winding M3 side) of the secondary winding may be connected to the ground terminal GND via the third resistor R3.

### Reference Sings List

A, A1, A2, A3...Phase Inverted Amplifier, Tr1...First Transistor, Tr2...Second Transistor, Tr3... Third Transistor, L1...Coil, T...Transformer, RFin... High Frequency Input Terminal, RFout...High Frequency Output Terminal, Cnt1...First Control Terminal, Cnt2...Second Control Terminal, Vcc... Power Terminal, GND...Ground Terminal

## Claims

1. A phase inverted amplifier comprising:
an amplifying transistor that amplifies an input signal;
two electronic switches each having a first end that is connected to an output end of the amplifying transistor, and that have ON/OFF states which are controlled by two control signals; and
a transformer that includes
a primary winding connected between two second ends of the two electronic switches, and
a secondary winding that outputs an amplification signal from a first end.

2. The phase inverted amplifier according to claim 1, wherein
the primary winding further comprises:
a first winding; and
a second winding; wherein
a first end of the first winding is connected to the second end of one of the two electronic switches, and
a first end of the second winding is connected to the second end of the other of the two electronic switches,
a second end of the first winding and a second end of the second winding are connected to a power terminal,
the secondary winding further comprises:
a third winding; and
a fourth winding; which are connected in series, wherein
a first end of the fourth winding is connected to the third winding, and a second end of the fourth winding is connected to a ground terminal, and
the first winding and the third winding are magnetically coupled to one another, the second winding and the fourth winding are magnetically coupled to one another, and an amplification signal is output from a first end of the third winding.

3. The phase inverted amplifier according to claim 1 or 2, wherein
the two electronic switches are switching transistors that are cascode connected to the amplifying transistor.

4. The phase inverted amplifier according to claim 1 or 2 further comprising:
a circuit element that adjusts at least one out of frequency characteristics, gain, or output impedance.

5. The phase inverted amplifier according to claim 1 or 2 further comprising:
a gain adjustment circuit that adjusts a degree of amplification of the amplifying transistor.
